# EUROPÄISCHE PATENTSCHRIFT

(11) **EP 1 371 803 B1**
(45) Veröffentlichungstag und Bekanntmachung des Hinweises auf die Patenterteilung: **07.09.2005**
(21) Anmeldenummer: 03101727.0
(22) Anmeldetag: 12.06.2003
(51) Int. Cl.: E05F 15/00

(54) **Vorrichtung zum Erkennen eines Hindernisses in dem Öffnungsbereich eines bewegbaren Schliesselements eines Kraftfahrzeugs**
Device for detecting an obstacle in the path of movement of an automobile electric window or sunroof pane
Dispositif pour la détection d'un objet dans la trajectoire d'un élément de fermeture déplaçable d'un véhicule

(30) Priorität: 12.06.2002 DE 10226133
(43) Veröffentlichungstag der Anmeldung: 17.12.2003
(73) Patentinhaber: METZELER Automotive Profiles GmbH, D-88131 Lindau (DE)
(72) Erfinder: Nuber, Roland, 88131, Lindau (DE)
(74) Vertreter: Schober, Christoph D.

(56) Entgegenhaltungen:
- EP-A- 1 154 110
- CH-A- 419 892
- DE-C- 10 220 725
- US-A- 4 016 490
- US-A- 6 051 981

## Beschreibung

Die Erfindung betrifft eine Vorrichtung zum Erkennen eines Hindernisses in dem Öffnungsbereich eines bewegbaren Schließelements eines Kraftfahrzeugs, insbesondere einer elektrisch angetriebenen Fensterscheibe oder eines Schiebedachs. Die Vorrichtung weist wenigstens eine ein elektrisches Feld in dem Öffnungsbereich des Schließelements erzeugende Sensorelektrode auf. Zudem ist die Vorrichtung mit einer Auswerteeinheit versehen, die eine kapazitive Änderung der Sensorelektrode infolge einer durch die Anwesenheit eines Hindernisses in dem Öffnungsbereich des Schließelements hervorgerufenen Änderung des elektrischen Felds erfaßt und ein Steuersignal für einen das Schließelement bewegenden Antrieb bereitstellt.

Derartige Vorrichtungen zum Erkennen eines Hindernisses stellen einen Einklemmschutz dar, der dazu dient, das Einklemmen etwa eines menschlichen Körperteils zwischen einer verfahrbar angetriebenen Fensterscheibe und einer die Fensterscheibe zumindest teilweise umgebenden Kante zu verhindern. Zu diesem Zweck weisen bekannte Vorrichtungen einen Sensor auf, der die Anwesenheit eines Hindernisses in dem Öffnungsbereich der ein Schließelement darstellenden Fensterscheibe erfaßt und ein Steuersignal für einen die Fensterscheibe bewegenden Antrieb bereitstellt. In Hinsicht auf die Funktionsweise des Sensors lassen sich die bekannten Vorrichtungen unterteilen in einen Einklemmschutz, der einen physischen Kontakt des Hindernisses mit dem Sensor erfordert, wie beispielsweise in der DE 199 13 105 A1 beschrieben wird, und einen Einklemmschutz, der berührungslos arbeitet.

Ein berührungslos arbeitender Einklemmschutz ist aus der EP 1 154 110 A2 bekannt. Die Wirkungsweise dieser Vorrichtung beruht auf einer durch ein elektrisch leitendes Hindernis hervorgerufenen Änderung der Kapazität eines zwischen zwei elektrischen Leitern erzeugten elektrischen Felds. Einer der beiden Leiter, die Sensorelektrode, ist in eine das Schliesselement abdichtende Dichtung integriert und wird mit einer vorgegebenen elektrischen Ladung beaufschlagt. Auf diese Weise lässt sich zwischen der Sensorelektrode und dem anderen Leiter, der Grundelektrode, die beispielsweise geerdet sein kann, eine Referenzkapazität bestimmen. Die Änderung der Referenzkapazität durch ein Hindernis wird mittels einer Auswerteeinheit erfasst, die ein Steuersignal für einen das Schliesselement bewegenden Antrieb bereitstellt.

Eine Vorrichtung und ein Verfahren zur Kennzeichnung der Bewegung einer Masse in einem definierten Raum wird in der US 6,051,981 beschrieben. Die bekannte Vorrichtung findet Anwendung, um die exakte Position eines Gegenstands oder einer Person in einem Raum zu bestimmen. Zu diesem Zweck wird mittels zweier Elektroden ein elektrisches Feld erzeugt, dessen Feldlinien beispielsweise von einer zu überwachenden Person unterbrochen werden. Veränderungen des elektrischen Felds werden an Hand eines in die jeweils andere Elektrode fliessenden Verschiebungsstroms gemessen, so dass sich Muster erzeugen lassen, die Auskunft über die Anwesenheit, Orientierung und Aktivität in dem definierten, das heisst zu überwachenden, Raum geben.

Die US 4,016,490 offenbart einen kapazitiven Näherungssensor, der mit einem Streufeldkondensator versehen ist. Der Streufeldkondensator weist wenigstens zwei in einer Ebene voneinander beabstandet angeordnete Flächenelektroden auf, von denen die eine als Sendeelektrode mit einem Signalgeber elektrisch leitend verbunden ist und die andere als Empfangselektrode an eine Auswerteeinheit angeschlossen ist. Die Auswerteeinheit wertet das auf Grund einer Änderung des Feldlinienverlaufs an der Empfangselektrode abgreifbare Messsignal aus. Die Sendeelektrode und die Empfangselektrode sind von einer gegen Masse isolierten, metallischen Abschirmung umgeben, über die im berührungslosen Zustand zumindest ein Teil der von der Sendeelektrode ausgehenden Feldlinien auf die Empfangselektrode weitergeleitet werden. Auf diese Weise werden die Feldlinien bei Annäherung oder Berührung der Abschirmung durch ein elektrisch leitendes Organ teilweise über dieses Organ abgeleitet.

Weiterhin offenbart die DE 296 16 654 U1 eine Vorrichtung zum Erkennen eines Hindernisses, die einen Sensor aufweist, der durch ein piezoelektrisches Kabel gebildet wird und mit einer Auswerteeinheit verbunden ist. Das piezoelektrische Kabel erzeugt sowohl bei einer radialen als auch bei einer axialen Druck- oder Zugbeanspruchung ein elektrisches Spannungssignal, das proportional zu der die Druck- oder Zugbeanspruchung hervorgerufenen Kraft ist. Wird eine solche Kraft durch ein Hindernis, beispielsweise in dem Öffnungsbereich eines Tors oder einer Fensterscheibe, hervorgerufen, lässt sich durch die Auswerteeinheit ein das Tor oder die Fensterscheibe steuerndes Signal bereitstellen.

Ein berührungslos arbeitender Einklemmschutz wird ausserdem in der DE 102 20 725 C1 beschrieben.

Der Erfindung liegt die **Aufgabe** zugrunde, eine Vorrichtung zum Erkennen eines Hindernisses in dem Öffnungsbereich eines bewegbaren Schließelements eines Kraftfahrzeugs dahingehend weiterzubilden, daß sich eine einfache Montage und ein unverfälschtes Meßergebnis erzielen lassen.

Zur **Lösung** dieser Aufgabe ist bei einer Vorrichtung mit den eingangs genannten Merkmalen in Übereinstimmung mit Anspruch 1 erfindungsgemäß vorgesehen, daß die Sensorelektrode durch einen geschirmten Leiter mit der Auswerteeinheit verbunden ist, wobei die Auswerteeinheit an einer elektronischen Steuerung des Antriebs angeordnet ist und den Einfluß des geschirmten Leiters auf das elektrische Feld kompensiert.

Das Vorsehen des geschirmten Leiters ermöglicht, die Auswerteeinheit in räumlicher Hinsicht unabhängig von der Sensorelektrode zu befestigen. Der durch die Abschirmung eine lediglich längenabhängige Kapazität aufweisende Leiter hat einen in etwa gleichbleibenden Einfluß auf das durch die Sensorelektrode erzeugte elektrische Feld. Demzufolge ist es ohne weiteres möglich, den Einfluß des geschirmten Leiters auf das elektrische Feld durch die Auswerteeinheit elektronisch zu kompensieren.

Die unmittelbar mit der elektronischen Steuerung des Antriebs verbundene Auswerteeinheit kann zusammen mit der elektronischen Steuerung und dem Antrieb beispielsweise in der Tür des Kraftfahrzeugs angeordnet sein. Eines Kabels, das die Auswerteeinheit mit der elektronischen Steuerung verbindet, bedarf es nicht, wodurch einer einfachen und in wirtschaftlicher Hinsicht kostengünstigen Fertigung Rechnung getragen wird. Dies gilt um so mehr, als ein die Auswerteeinheit mit der elektronischen Steuerung verbindendes Kabel zweckmäßigerweise mit einer Zugentlastung von wenigstens 50 N zu versehen ist, um einer praxisgerechten Montage zu genügen. Der mit einer solchen Zugentlastung verbundene konstruktive Aufwand ist somit hinfällig. Die unmittelbare Anordnung der Auswerteeinheit an der elektronischen Steuerung des Antriebs gewährleistet zudem einen kurzen Weg für das durch die Auswerteeinheit bereitgestellte Steuersignal. Dies trägt zu einer hohen Zuverlässigkeit und Genauigkeit des Steuersignals bei.

Vorteilhafte Weiterbildungen der erfindungsgemäßen Vorrichtung stellen die Gegenstände der Ansprüche 2 bis 5 dar.

Vorteilhafterweise ist die Auswerteeinheit vorzugsweise über den Antrieb geerdet, um das durch die Sensorelektrode erzeugte elektrische Feld nicht zu beeinflussen.

Bevorzugt ist der geschirmte Leiter mittels eines Steckers an der elektronischen Steuerung angeschlossen, um eine einfache Montage zu gewährleisten.

In einer vorteilhaften Ausgestaltung der erfindungsgemäßen Anordnung ist die Auswerteeinheit in den Stecker integriert. Eine solche Ausgestaltung ermöglicht eine in fertigungstechnischer Hinsicht günstige Vorkonfektionierung der aus geschirmtem Leiter, Stecker, Auswerteeinheit und je nach Anwendungsfall auch aus der Sensorelektrode bestehenden Baueinheit.

Schließlich wird als alternative Weiterbildung der erfindungsgemäßen Anordnung vorgeschlagen, die Auswerteeinheit in die elektronische Steuerung des Antriebs zu integrieren. In diesem Fall kann eine aus dem geschirmten Leiter, dem Stecker und gegebenenfalls der Sensorelektrode bestehende Baueinheit, die somit über lediglich mechanische Komponenten verfügt, auf einfache Weise vorgefertigt werden. Darüber hinaus können die Auswerteeinheit und die elektronische Steuerung beispielsweise auf ein und derselben Leiterplatte angeordnet werden, um eine kompakte Ausgestaltung zu gewährleisten.

Einzelheiten und weitere Vorteile der erfindungsgemäßen Anordnung ergeben sich aus der nachfolgenden Beschreibung bevorzugter Ausführungsbeispiele. In den die Ausführungsbeispiele lediglich schematisch darstellenden Zeichnungen veranschaulichen im einzelnen:
- Fig. 1: eine Seitenansicht eines Kraftfahrzeugs;
- Fig. 2: eine schematische Darstellung einer Vorrichtung zum Erkennen eines Hindernisses;
- Fig. 3: eine schematische Darstellung einer ersten Ausführungsform der erfindungsgemäßen Vorrichtung und
- Fig. 4: eine schematische Darstellung einer zweiten Ausführungsform der erfindungsgemäßen Vorrichtung.

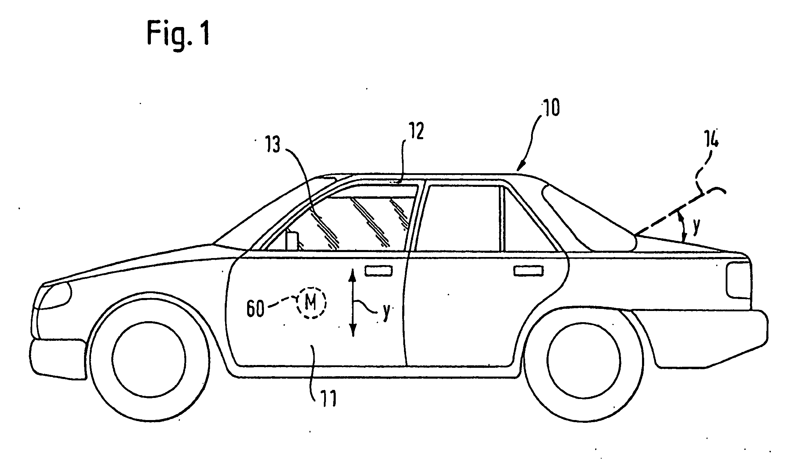

In Fig. 1 ist ein Kraftfahrzeug 10 dargestellt, das im Bereich einer Vordertür 11 mit einer durch einen Elektromotor 60 angetriebenen Fensterscheibe 13 versehen ist. Die ein Schließelement darstellende Fensterscheibe 13 ist in Verfahrrichtung y des Elektromotors 60 zwischen einer Offenstellung und einer durch einen Rahmen 12 der Vordertür 11 begrenzten Schließstellung verfahrbar. An dem Rahmen 12 ist eine nicht gezeigte Dichtung befestigt, welche die Fensterscheibe 13 abdichtet. In die aus einem elastomeren Werkstoff, beispielsweise EPDM, gefertigte Dichtung ist eine Sensorelektrode 20 eingebettet, wie sie in der EP 1 154 110 A2 beschrieben ist. Die Sensorelektrode 20 dient dazu, ein elektrisches Feld in dem Öffnungsbereich der Fensterscheibe 13 zu erzeugen, wobei der geerdete Rahmen 12 oder ein anderer geerdeter Leiter die hierzu erforderliche Gegenelektrode darstellt. Eine mit der Sensorelektrode 20 verbundene Auswerteeinheit 30 erfaßt die durch ein elektrisch leitendes Hi n-demis im Bereich des elektrischen Felds an der Sensorelektrode 20 hervorgerufene Änderung der Kapazität und stellt in Abhängigkeit von der Änderung ein Steuersignal für den Elektromotor 60 bereit, das im Bedarfsfall den Elektromotor 60 stoppt.

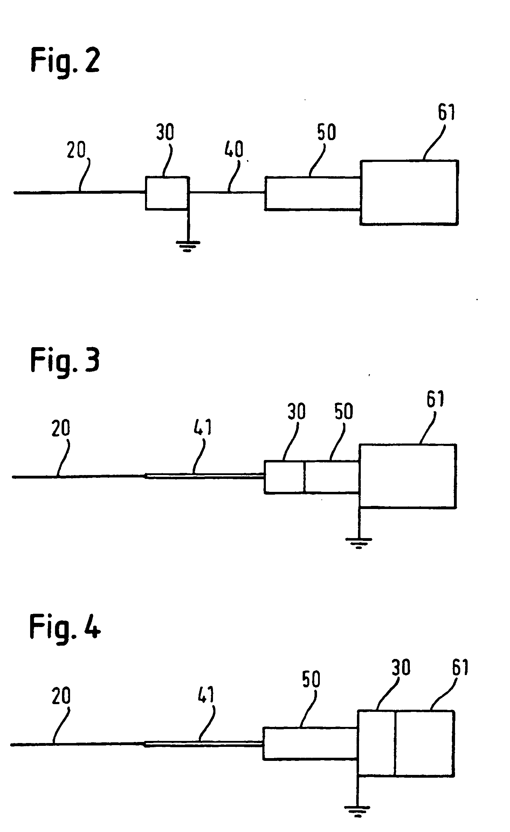

Bei der in Fig. 2 dargestellten Ausführungsform ist die Sensorelektrode 20 unmittelbar mit der Auswerteeinheit 30 verbunden. Die Auswerteeinheit 30 ist geerdet und durch ein Kabel 40 mit einer elektronischen Steuerung 61 des Antriebs 60 verbunden. Das Kabel 40 weist an dem der Auswerteeinheit 30 abgewandten Ende einen Stecker 50 auf, der dazu dient, das Kabel 40 lösbar an einer elektronischen Steuerung 61 des Elektromotors 60 anzuschließen. Demzufolge ist es möglich, die sich aus der Auswerteeinheit 30, dem Kabel 40 und dem Stecker 50 zusammensetzende Baueinheit vorzukonfektionieren und bei der Montage des Kraftfahrzeugs 10 mit der elektronischen Steuerung 61 des Antriebs 60 und der in der Dichtung eingebetteten Sensorelektrode 20 zu verbinden. Alternativ kann die vorkonfektionierte Baueinheit auch die Sensorelektrode 20 umfassen. Eine derartige Ausgestaltung bietet sich beispielsweise dann an, wenn die Sensorelektrode 20 nicht in der die Fensterscheibe 13 abdichtenden Dichtung eingebettet sondern an einer Verkleidung oder ähnlichem angeordnet ist.

Demgegenüber ist bei der in Fig. 3 dargestellten Ausführungsform die Steuerelektrode 20 durch einen geschirmten Leiter 41 mit der Auswerteeinheit 30 verbunden. Die Auswerteeinheit 30 ist in den Stecker 50 integriert, der an dem der Steuerelektrode 20 abgewandten Ende des geschirmten Leiters 41 angeordnet ist. Die auf diese Weise unmittelbar mit der elektronischen Steuerung 61 des Elektromotors 60 verbundene Auswerteeinheit 30 wird durch den Elektromotor 60 geerdet. Der geschirmte Leiter 41, der die Auswerteeinheit 30 beinhaltende Stecker 50 und gegebenenfalls die Sensorelektrode 20 können als vorkonfektionierte Baueinheit ausgebildet sein.

Die in Fig. 4 gezeigte Ausführungsform unterscheidet sich von der Ausführungsform gemäß Fig. 3 in erster Linie darin, daß die Auswerteeinheit 30 nicht in den Stecker 50 sondern in die elektronische Steuerung 61 integriert ist. Auf diese Weise können die Sensorelektrode 20, der geschirmte Leiter 41 und der Stecker 50 als Baueinheit vorkonfektioniert werden, die lediglich mechanische Komponenten aufweist. Die Auswerteeinheit 30 und die elektronische Steuerung 61 befinden sich in unmittelbarer Nähe des Elektromotors 60 auf ein und derselben Leiterplatte.

Die zuvor beschriebenen Ausführungsformen einer Vorrichtung zum Erkennen eines Hindernisses in dem Öffnungsbereich der durch den Elektromotor 60 angetriebenen Fensterscheibe 13 des Kraftfahrzeugs 10 stellen einen Einklemmschutz dar, der in analoger Weise beispielsweise bei einem Schiebedach, einer Schiebetür, einer Heckklappe oder einem Kofferraumdeckel 14 des Kraftfahrzeugs 10 Anwendung finden kann. Den Vorrichtungen ist gemeinsam, daß die Sensorelektrode 20 derart plazierbar ist, daß in dem Öffnungsbereich der Fensterscheibe 13 beziehungsweise des Kofferraumdeckels 14 oder eines anderen Schließelements des Kraftfahrzeugs 10 ein elektrisches Feld erzeugt wird. Die Anordnungen unterscheiden sich allerdings durch die Verbindung der Sensorelektrode 20 mit der eine durch die Anwesenheit eines Hindernisses in dem Öffnungsbereich der Fensterscheibe 13 hervorgerufene kapazitive Änderung des elektrischen Felds erfassenden Auswerteeinheit 30. Die in Fig. 2 dargestellte Vorrichtung ist durch die unmittelbare Anordnung der Auswerteeinheit 30 an der Sensorelektrode 20 gekennzeichnet. Demgegenüber ist es bei den in den Fig. 3 und 4 gezeigten Vorrichtungen, bei denen die Auswerteeinheit 30 unmittelbar an der elektronischen Steuerung 61 angeordnet ist, erforderlich, die durch den geschirmten Leiter 41 hervorgerufene Kapazität bei der Erfassung der kapazitiven Änderung des elektrischen Felds zu kompensieren. Auf Grund der Abschirmung ist der durch den Leiter 41 auf das elektrische Feld ausgeübte Einfluß allerdings annähernd konstant, so daß sich eine elektronische Kompensation durch die Auswerteeinheit 30 verhältnismäßig einfach realisieren läßt.

Nicht zuletzt trägt das Vorsehen des Steckers 50 bei jeder in den Fig. 2 bis 4 dargestellten Vorrichtung für einen berührungslos arbeitenden Einklemmschutz einer einfachen Montage und einer in wirtschaftlicher Hinsicht kostengünstigen Fertigung Rechnung.

### Bezugszeichenliste

- 10: Kraftfahrzeug
- 11: Vordertür
- 12: Rahmen
- 13: Fensterscheibe
- 14: Kofferraumdeckel

- 20: Sensorelektrode

- 30: Auswerteeinheit

- 40: Kabel
- 41: geschirmter Leiter

- 50: Stecker

- 60: Elektromotor
- 61: elektronische Steuerung

- y: Verfahrrichtung

## Patentansprüche

1. Vorrichtung zum Erkennen eines Hindernisses in dem Öffnungsbereich eines bewegbaren Schließelements (13) eines Kraftfahrzeugs (10), insbesondere einer elektrisch angetriebenen Fensterscheibe (13) oder eines Schiebedachs, mit wenigstens einer Sensorelektrode (20), die ein elektrisches Feld in dem Öffnungsbereich des Schließelements (13) erzeugt, und einer Auswerteeinheit (30), die eine kapazitive Änderung der Sensorelektrode (20) infolge einer durch die Anwesenheit eines Hindernisses in dem Öffnungsbereich des Schließelements (13) hervorgerufenen Änderung des elektrischen Felds erfaßt und ein Steuersignal für einen das Schließelement (13) bewegenden Antrieb (60) bereitstellt, **dadurch gekennzeichnet, daß** die Sensorelektrode (20) durch einen geschirmten Leiter (41) mit der Auswerteeinheit (30) verbunden ist, wobei die Auswerteeinheit (30) an einer elektronischen Steuerung (61) des Antriebs (60) angeordnet ist und den Einfluß des geschirmten Leiters (41) auf das elektrische Feld kompensiert.

2. Vorrichtung nach Anspruch 1, **dadurch gekennzeichnet, daß** die Auswerteeinheit (30) vorzugsweise über den Antrieb (60) geerdet ist.

3. Vorrichtung nach Anspruch 1 oder 2, **dadurch gekennzeichnet, daß** der geschirmte Leiter (41) mittels eines Steckers (50) an der elektronischen Steuerung (61) angeschlossen ist.

4. Vorrichtung nach Anspruch 3, **dadurch gekennzeichnet, daß** die Auswerteeinheit (30) in den Stecker (50) integriert ist.

5. Vorrichtung nach einem der Ansprüche 1 bis 4, **dadurch gekennzeichnet, daß** die Auswerteeinheit (30) in die elektronische Steuerung (61) des Antriebs (60) integriert ist.

## Claims

1. A device for sensing an obstacle in the opening range of a movable closure element (13) of a motor vehicle (10), more particularly an electrically powered window pane (13) or sunroof, comprising at least one sensor electrode (20) generating an electrical field in the opening range of said closure element (13) and a control unit (30) detecting a capacitance change of the sensor electrode (20) due to the change in the capacitance of the electrical field caused by the presence of an obstacle in the opening range of said closure element (13) and providing a control signal for a drive (60) powering said closure element (13), **characterized by** said sensor electrode (20) being connected to said control unit (30) by a shielded conductor (41), said control unit (30) being arranged on an electronic controller (61) of said drive (60) and compensating the influence of said shielded conductor (41) on said electrical field.

2. The device as set forth in claim 1, **characterized in that** said control unit (30) is grounded preferably by said drive (60).

3. The device as set forth in claim 1 or 2, **characterized in that** said shielded conductor (41) is connected to said electronic controller (61) by means of a connector (50).

4. The device as set forth in claim 3, **characterized in that** said control unit (30) is integrated in said connector (50).

5. The device as set forth in any of the claims 1 to 4, **characterized in that** said control unit (30) is integrated in said electronic controller (61) of said drive (60).

## Revendications

1. Dispositif pour détecter un obstacle dans la zone d'ouverture d'un élément de fermeture déplaçable (13) d'un véhicule automobile (10), en particulier d'une vitre de fenêtre (13) ou d'un toit coulissant à entraînement électrique, comprenant au moins une électrode de détection (20) qui engendre un champ électrique dans la zone d'ouverture de l'élément de fermeture (13) et une unité d'évaluation (30) qui détecte une modification capacitive de l'électrode de détection (20) à la suite d'une modification du champ électrique provoquée par la présence d'un obstacle dans la zone d'ouverture de l'élément de fermeture (13) et qui prépare un signal de commande pour l'entraînement (60) qui entraîne l'élément de fermeture (13), **caractérisé en ce que** l'électrode de détection (20) est reliée à l'unité d'évaluation (30) par une ligne blindée (41), et l'unité d'évaluation (30) est agencée sur une commande électronique (61) de l'entraînement (60) et compense l'influence de la ligne blindée (41) sur le champ électrique.

2. Dispositif selon la revendication 1, **caractérisée en ce que** l'unité d'évaluation (30) est mise à la terre, de préférence via l'entraînement (60).

3. Dispositif selon l'une ou l'autre des revendications 1 et 2, **caractérisée en ce que** la ligne blindée (41) est raccordée à la commande électronique (61) au moyen d'une prise (50).

4. Dispositif selon la revendication 3, **caractérisée en ce que** l'unité d'évaluation (30) est intégrée dans la prise (50).

5. Dispositif selon l'une des revendications 1 à 4, **caractérisée en ce que** l'unité d'évaluation (30) est intégrée dans la commande électronique (61) de l'entraînement (60).
